# EUROPEAN PATENT APPLICATION

(11) **EP 1 296 146 A1**
(43) Date of publication of application: **26.03.2003**
(21) Application number: 01402436.8
(22) Date of filing: 21.09.2001
(51) Int. Cl.: G01R 21/01

(54) **RF signal detector circuit with reduced sensitivity to transmission line impedance mismatches**

(71) Applicant: ALCATEL, 75008 Paris (FR)
(72) Inventor: Lodi, Umberto, 23807 Merate (Lecco) (IT); Villa, Alberto, 21100 Varese (IT)
(74) Representative: Colombo, Stefano Paolo

(57) **Abstract**

An RF signal detector circuit and a method for monitoring the level of Radio Frequequency signals flowing through a trasmission line are disclosed. The RF detector circuit comprises: a first RF coupling device (181) connected to a transmission line (12) for receiving RF samples; and a first RF detector (201) responsive to an output of the RF coupling device (181). It is characterized in that it also comprises a further RF coupling device (182); and a further RF detector (202) responsive to said further RF coupling device (182), both said RF coupling devices (181, 182) being connected to the transmission line and placed at a distance (*I*_{*C*}) from each other that is an odd multiple of one-quarter of wavelength λ.

## Description

The present invention relates to an RF signal detector and a method for monitoring the level of Radio Frequequency signals flowing through a trasmission line.

There are several microwave circuits wherein it is important to monitor the level of the RF signal flowing through a transmission line. Exemplificative microwave circuits could be, for instance, RF power amplifiers or local oscillators. The main requirements for an ideal detector are two:
i. The source should not be appreciably loaded by the detector, namely only a small fraction of the power in transit shall be coupled from the line to the detector;
ii. The detected level should be proportional to the amplitude of the incident wave, and it should not depend on the mismatch of the load that terminates the main transmission line.

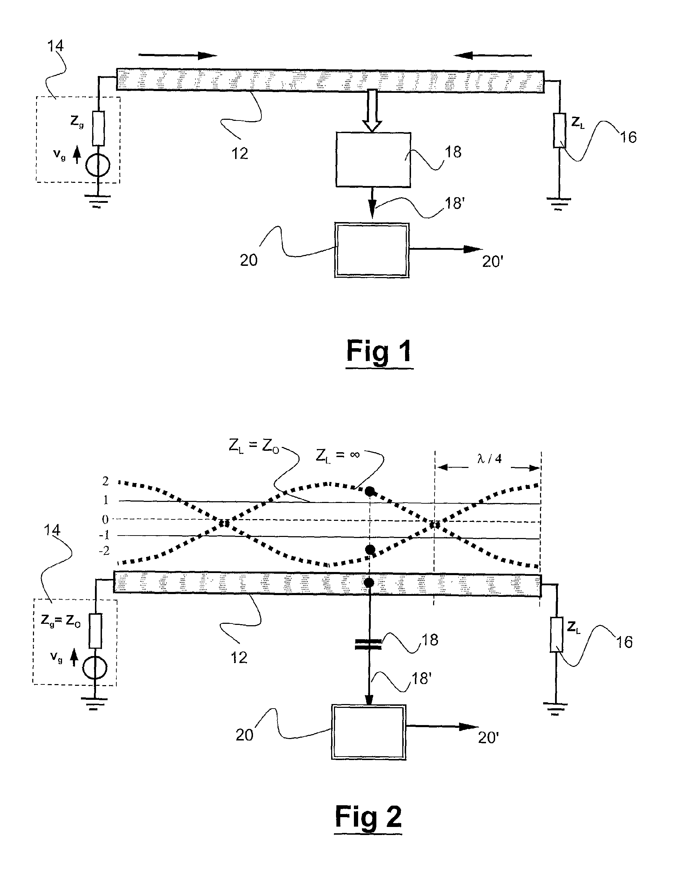

The block diagram of Fig. 1 shows a known circuit used for detecting an RF signal flowing in a transmission line. The known circuit comprises:
a coupling device, which extracts a proper fraction of the RF power from the transmission line; and
an RF detecting device (typically a Schottky diode with relevant RF matching and DC bias network) connected to the coupling device.

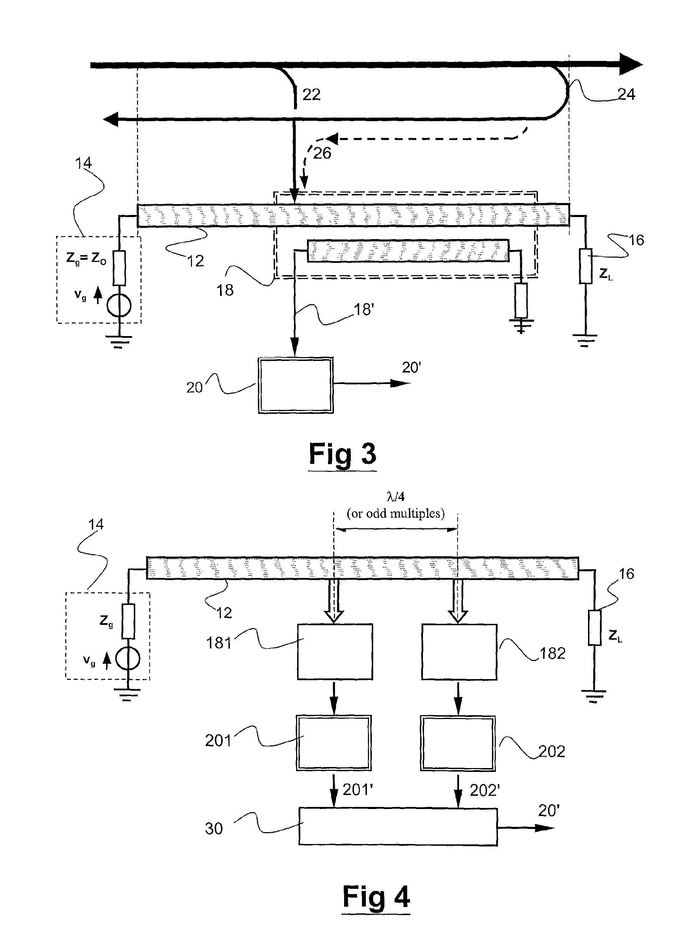

The coupling device can be implemented, for instance, through a high Q and low-value capacitor (see Fig. 2); or a directional coupler (see Fig. 3).

The known circuits used for detecting an RF signal flowing in a transmission line have some drawbacks.

In the known devices wherein the coupling device is implemented by capacitive coupling, the detected voltage level is very dependent on the return loss of the load that terminates the transmission line. This means that a mismatch creates standing waves and thus the voltage delivered by the diode can change considerably depending on the position of the standing wave pattern with respect to the capacitor connection point.

As shown in Fig. 2, in the worst case of an open ended (or shortcircuited) lossless transmission line, the detected voltage level can be anywhere between twice the incident wave amplitude and zero (which means an error between +6 dB and -∞ dB, or +/- 100%). An output isolator (or an attenuating pad) is thus necessary, to reduce the standing waves amplitude under different load conditions (and signal frequencies), in order to obtain a more stable detected voltage. The consequent disadvantage is that an output isolator is a rather expensive device and an attenuating pad dissipates "precious" RF power.

The known devices wherein the coupling device is implemented by a directional coupler are usually better than the previous ones because the directional coupler should in fact take a sample of the incident (direct) RF wave and reject the reflected one. Unfortunately, as shown in Fig. 3, the directivity of the coupler is not infinite. In turn, this means that a portion of the reflected wave energy will reach the coupler output, and thus the RF detector, adding vectorially with the main coupled one. So, also in this case, it is advisable to use an RF isolator (or an attenuating pad).

In both cases, the situation can be further complicated by the possible mismatch of the signal source, which means that part of the energy reflected by the load is re-reflected back by the generator, and reaches in this way the coupler output (attenuated by the coupling factor).

In view of the above known solutions and the corresponding drawbacks, the main object of the present invention is providing an RF signal detector circuit with reduced sensitivity to transmission line impedance mismatches without using an expensive microwave isolator or an RF power absorbing attenuating pad.

This and further objects are obtained by an RF signal detector circuit having the features set forth in claim 1 and by a method comprising the steps set forth in claim 8. Further advantageous features of the invention are indicated in the respective dependent claims. All the claims are intended to be an integral part of the present description.

The basic idea of the present invention is to have two RF coupling devices (with relevant detectors) connected to the transmission line and placed at a distance *I*_{*C*} from each other, wherein *I*_{*C*} is an odd multiple of one-quarter wavelength, namely *I*_{*C*} = (2*n*+1)·λ/4 where *n* = 0, 1, 2, 3,... etc. This is the distance existing between minimums and maximums of the standing wave pattern in case of mismatched load.

The present invention will become clear in view of the following description, given by way of non limiting example, to be read with reference to the attached sheets of drawings, wherein:
- Fig. 1 shows a general block diagram of an RF signal detection circuit according to the prior art;
- Fig. 2 shows the detector circuit of Fig. 1, wherein the coupling device comprises a capacitive coupling;
- Fig. 3 shows the detector circuit of Fig. 1, wherein the coupling device comprises a directional coupling;
- Fig. 4 shows a general block diagram of an RF signal detection circuit according to the present invention;
- Fig. 5 shows the detector circuit of Fig. 4 comprising two coupling capacitors;
- Fig. 6 shows the detector circuit of Fig. 4 comprising two directional couplers;
- Fig. 7 shows an example of voltage sum with passive network;
- Fig. 8 shows an example of voltage sum with active network;
- Fig. 9 shows a simulation of ideal system with capacitive coupling and Standing Wave Ratio equal to ∞; and
- Fig. 10 shows a simulation of ideal system with capacitive coupling and Standing Wave Ratio equal to 2 (Return Loss = 9,5 dB).

In Fig. 1, a general block diagram of an RF signal detection circuit according to the prior art is shown. The detection circuit 10 comprises a transmission line 12 (having impedance *Z*_{*O*}), a generator 14 and a load 16. An RF sample is extracted from transmission line and sent to an RF coupling device 18 and to an RF detector 20 outputting an RF detector output voltage 20'. In Fig. 1, the incident and reflected waves are indicated by the left (directed to the right) and right (directed to the left) arrows, respectively.

Fig. 2 shows the same RF signal detector as the detector of Fig. 1 wherein the coupling device comprises a capacitive coupling. Furthermore, in Fig. 2, voltage amplitude with matched load (*Z*_{*L*} = *Z*_{*O*}) has been indicated by a corresponding horizontal line and standing waves voltage amplitude in case of *Z*_{*L*} = ∞ has been also indicated by bold dotted waves.

In Fig. 3, the RF signal detector of Fig. 1 wherein the coupling device comprises a directional coupler is shown. As said above, such a solution is considered better than the capacitive coupling arrangement because a sample of the direct RF wave is taken (22) but the reflected wave is rejected (24). Unfortunately, the coupler directivity is finite (see dotted line indicated by 26) and a portion of reflected wave energy will reach the coupler output.

Fig. 4 shows a general block diagram of an RF signal detection circuit according to the present invention. As it is clear, the novel detector comprises two RF coupling devices 181, 182 and two corresponding RF detectors 201, 202. The two RF coupling devices are connected to the transmission line 12 and placed at a distance *I*_{*C*} from each other. *I*_{*C*} is an odd multiple of one-quarter wavelength, namely *I*_{*C*} = (2*n*+1)·λ/4 where *n* = 0, 1, 2, 3,... etc. This is the distance existing between minimums and maximums of the standing wave pattern in case of mismatched load.

Preferably, for a wider bandwidth, the preferred choice is *n* = 0, which means *I*_{*C*} *=* λ/4.

The voltages 201' and 202' coming from the two detectors 201 and 202 are summed together by means of a suitable summing network, and the resulting output level will be considerably less sensitive to the impedance mismatches (standing waves) of the RF transmission line.

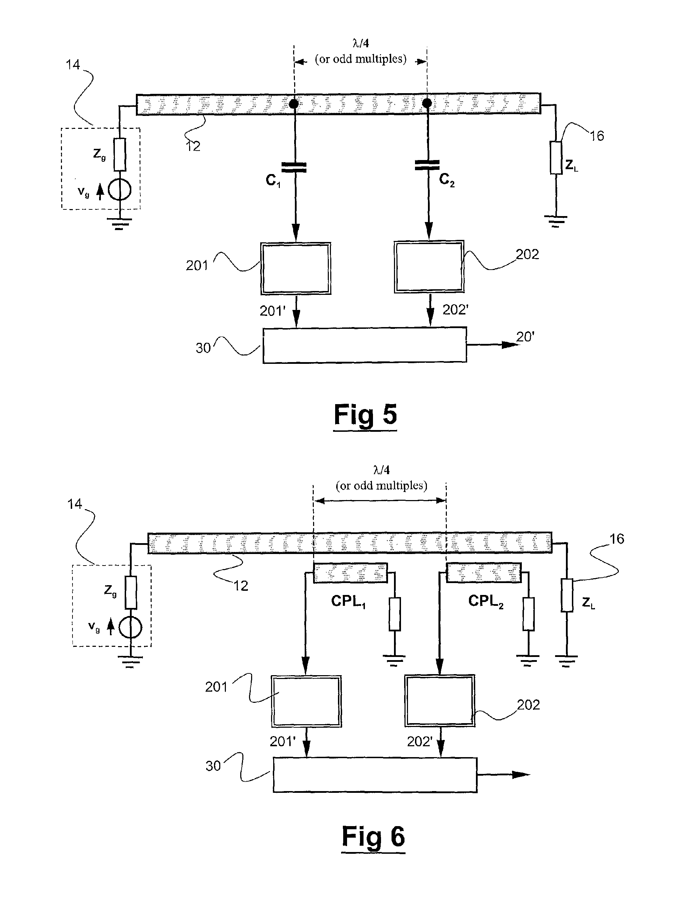

The present invention can be implemented in different ways, depending on the RF coupling system. For instance, as shown in Fig. 5, a sample of the RF signal power can be taken by means of two RF capacitors *C*₁ and *C*₂, λ/4 spaced (or odd multiples thereof) from each other; in case of microstrip implementation, this requires the minimum printed circuit space but at a higher cost (two RF capacitors).

An alternative arrangement is shown in Fig. 6 and comprises two directional couplers CPL₁ and CPL₂, spaced λ/4 (or odd multiples thereof) from each other. The directional couplers CPL₁ and CPL₂ could be placed on the same side or on the opposite sides of the transmission line 12.

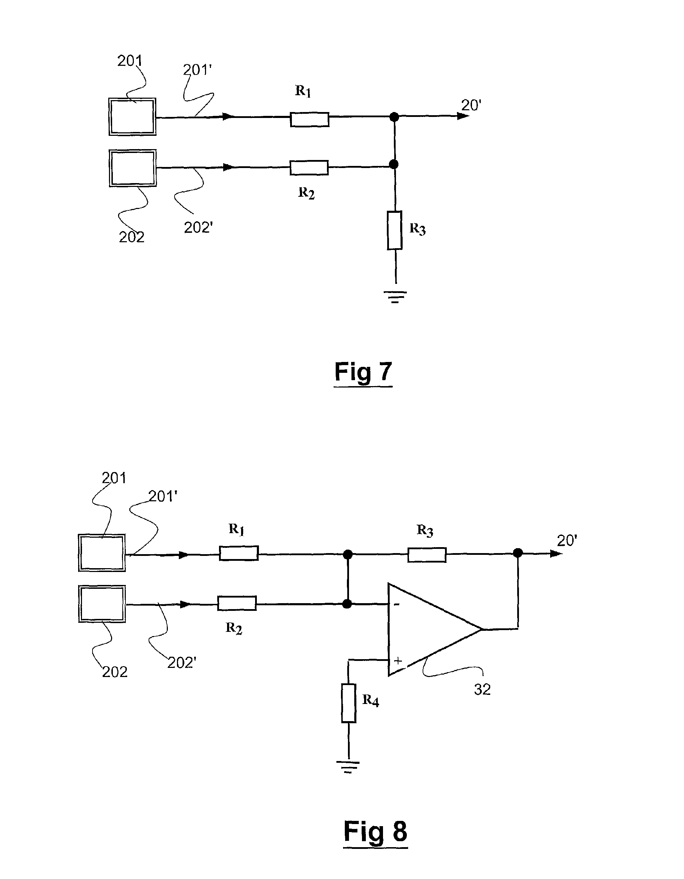

In both cases the overall detector output voltage is obtained by summing together the voltages generated by the two diodes through a proper summing circuit. The summing circuit can comprise a resistive network (see Fig. 7) or an active network, for instance an operational amplifier summer 32 (see Fig. 8). The suming circuit comprising an active network is the most effective and preferred solution.

To optimize the arrangement of Fig. 8, the two crystal detectors should be matched (selected) pairs, and a means for adjusting the balance of their two outputs should be provided.

Ideally, in the resistive network of Fig. 7, *R*₁*= R*₂ = *R* >> *R*₃ . In practice, *R*₁ (or *R*₂) can be adjusted to balance the outputs of the two RF detectors.

Ideally, in the active network of Fig. 8, *R*₁ = *R*₂ = *R, R*₄ = *R*₁*∥R*₂*∥R*₃ and Voltage Gain = *-R*₃ /*R*. In practice, *R*₁ (or *R*₂) can be adjusted to balance the outputs of the two RF detectors.

Preferably, the summing networks (or the single RF detectors) can be completed with temperature compensating circuits (not shown in the drawings).

Ideal performances are obtained when the two RF detectors 201, 202 give identical responses and when the transmission line is lossless. In practice there will be a certain degree of unbalance due to differences in the RF coupling factors (element tolerances); differences in the efficiency of the two detectors; and slightly less power reaching the second coupler (far from the generator), because a small amount of RF power is absorbed by the first coupler and further because some RF power is dissipated in the line between the two coupling devices.

If necessary, these impairments can be compensated by using matched diode pairs or by trimming the coupling factor (and/or the summing network).

The main advantages of the present invention will now be clear. The output level of the RF signal detector according to the present invention exhibits a reduced sensitivity to the main transmission line impedance mismatches, without requiring an expensive microwave isolator or an RF power-absorbing attenuating pad.

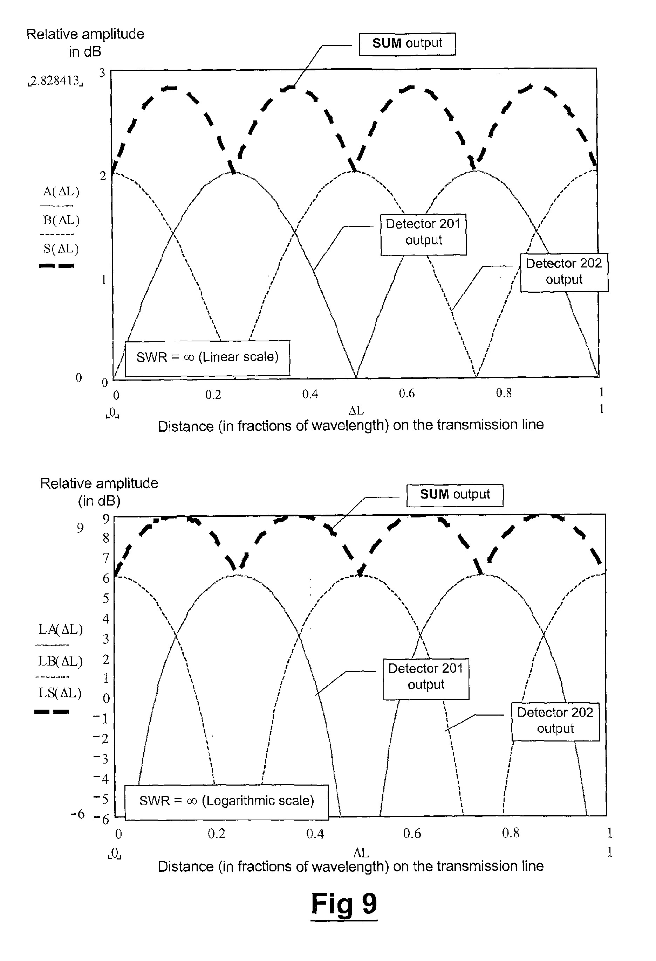

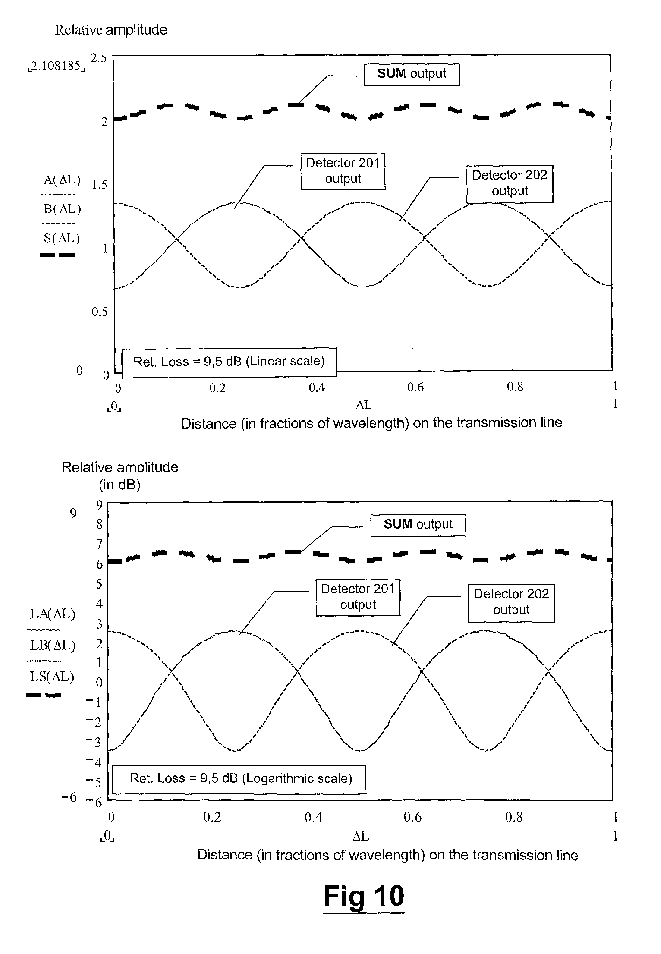

Figures 9 and 10 show computer simulations of ideal systems with capacitive coupling and Standing Wave Ratio (SWR) equal to ∞ and 2, respectively. As shown in the simulation results of Fig. 9, with the very critical capacitive coupling scheme of Fig. 2, and supposing an ideal circuit (identical coupling capacitors and detectors), in the worst case of an open or shortcircuited lossless line, the +/-100% (+6 dB / -∞ dB) original uncertainity of the detected level will be reduced to +41/-0% (or +3 dB / 0 dB). In case of an SWR equal to 2 (return loss of 9,5 dB), the detector fluctuations will be reduced from +/- 33% (+2,5 dB / -3,5 dB) to +5,4/-0% (+0,5 dB / 0 dB), as shown in Fig. 10.

The present invention can be employed by all manufacturers of RF microwave amplifiers, local oscillators and/or generic RF microwave frequency sources.

In view of the above description of RF signal detector circuit and operation thereof, the method steps can be summarized as follow: a method for monitoring the level of RF signals flowing through a trasmission line 12, comprising the steps of: connecting a first RF coupling device 181 to the transmission line 12 for receiving RF samples; and providing a first RF detector 201 responsive to an output of the RF coupling device 181, characterized by the steps of connecting a further RF coupling device 182 to the transmission line 12 for receiving further RF samples; and providing a further RF detector 202 responsive to said further RF coupling device 182, wherein both said RF coupling devices 181, 182 are connected to the transmission line and placed at a distance *I*_{*C*} from each other that is an odd multiple of one-quarter wavelength λ.

There have thus been shown and described a novel RF signal detector circuit and a novel method which fulfill all the objects and advantages sought therefor. Many changes, modifications, variations and other uses and applications of the subject invention will, however, become apparent to those skilled in the art after considering the specification and the accompanying drawings which disclose preferred embodiments thereof. All such changes, modifications, variations and other uses and applications which do not depart from the spirit and scope of the invention are deemed to be covered by the invention which is limited only by the claims which follow.

## Claims

1. RF signal detector circuit comprising:
a first RF coupling device (181) connected to a transmission line (12) for receiving RF samples; and
a first RF detector (201) responsive to an output of the RF coupling device (181),
**characterized in that** it also comprises
a further RF coupling device (182); and
a further RF detector (202) responsive to said further RF coupling device (182), both said RF coupling devices (181, 182) being connected to the transmission line and placed at a distance (*I*_{*C*}) from each other that is an odd multiple of one-quarter of wavelength λ.

2. Detector circuit according to claim 1, **characterized in that** it further comprises a voltage summing network (30) for summing the outputs (201', 202') of the first and further RF detectors (201, 202) and outputting a detector output voltage (20').

3. Detector circuit according to claim 1 or 2, **characterized in that** said first and further RF coupling devices (181, 182) comprise a first and a further capacitors (C₁, C₂).

4. Detector circuit according to claim 1 or 2, **characterized in that** said first and further RF coupling devices (181, 182) comprise a first and a further directional couplers (CPL₁, CPL₂).

5. Detector circuit according to any of claims 2-4, **characterized in that** said voltage summing network (30) comprises a passive network.

6. Detector circuit according to any of claims 2-4, **characterized in that** said voltage summing network (30) comprises an active network comprising an operational amplifier (32).

7. Detector circuit according to any of the preceding claims, **characterized in that** the distance (*I*_{*C*}) between RF coupling devices (181, 182) is λ/4.

8. Method for monitoring the level of RF signals flowing through a trasmission line (12), comprising the steps of:
connecting a first RF coupling device (181) to the transmission line (12) for receiving RF samples; and
providing a first RF detector (201) responsive to an output of the RF coupling device (181),
**characterized by** the steps of:
connecting a further RF coupling device (182) to the transmission line (12) for receiving further RF samples; and
providing a further RF detector (202) responsive to said further RF coupling device (182), wherein both said RF coupling devices (181, 182) are connected to the transmission line and placed at a distance (*I*_{*C*}) from each other that is an odd multiple of one-quarter wavelength λ.

9. Method according to claim 8, **characterized by** the step of summing the outputs (201', 202') of the first and further RF detectors (201, 202) for outputting a detector output voltage (20').
